# EUROPÄISCHE PATENTSCHRIFT

(11) **EP 1 162 694 B1**
(45) Veröffentlichungstag und Bekanntmachung des Hinweises auf die Patenterteilung: **07.05.2008**
(21) Anmeldenummer: 01113462.4
(22) Anmeldetag: 02.06.2001
(51) Int. Cl.: H01R 12/08, H01R 4/10

(54) **Vorrichtung zum Verbinden von elektrischen Leitern**
Apparatus for connecting electrical wires
Appareil pour la connexion de conducteurs électriques

(30) Priorität: 09.06.2000 DE 10028184
(43) Veröffentlichungstag der Anmeldung: 12.12.2001
(73) Patentinhaber: Hirschmann Automotive GmbH, 6830 Rankweil-Brederis (AT); LEONI Bordnetz-Systeme GmbH & Co KG, 90402 Nürnberg (DE)
(72) Erfinder: Feder, Roland, 6820 Gurtis (AT); Ellensohn, Kurt, 6840 Götzis (AT); Engbring, Jürgen, Dr., 97346 Iphofen (DE); Miersch, Erik, 97355 Wiesenbronn (DE)
(74) Vertreter: Thul, Hermann

(56) Entgegenhaltungen:
- DE-A- 3 029 041
- DE-A- 19 832 011
- US-A- 4 184 729

## Beschreibung

Die Erfindung betrifft eine Vorrichtung zum Verbinden von elektrischen Leitern wie Flachbandleitungen, Leiterplatten, Leiterfolien oder dergleichen.

Eine Vorrichtung zur Verbindung von Flachbandleitungen ist aus der DE 198 32 011 A1 bekannt. Die Flachbandleitung weist einen zum lösbarem Verbinden vorgesehenen Anschlußbereich auf, wobei dem Anschlußbereich ein Isolierstoffgehäuse zugeordnet ist, welches zum Aufbringen der notwendigen Kontaktkräfte Federmittel aufweist, die den einzelnen Leiterbahnen der Flachbandleitung derart zugeordnet sind, so daß die Flachbandleitungen mit ihren durch Abisolation geschaffenen Kontaktbereichen unter Federwirkung der Federmittel direkt an den zugeordneten Gegenkontaktbereichen des zu kontaktierenden Gegenteiles zur Anlage kommen. Dabei ist wesentlich, daß je Kontaktbereich zumindest eine direkt aus der Flachbandleitung ausgestellte und erhabene Kontaktwölbung mit einer plastisch fertig ausgeformten Kontur vorhanden ist, wobei dann nach der Kontaktierung die dem Gegenteil abgewandte Rückseite der erhabenen Kontaktwölbungen direkt von einem Federmittel beaufschlagt ist. Das heißt, daß nach der Kontaktierung die Oberfläche der Kontaktwölbung federkraftbeaufschlagt auf dem Anschlußbereich des Gegenstückes aufliegt. Das Gegenstück selber ist ebenfalls eine Flachbandleitung.

Eine auf diese Art und Weise geschaffene Verbindung (Kontaktierung) von Flachbandleitungen hat sich an für sich bewährt. Es hat sich jedoch herausgestellt, daß der Kontakt sofort verloren geht, wenn keine Federwirkung mehr vorhanden ist. Dies kann beispielsweise bei der DE 198 32 011 A1 dadurch passieren, daß die als Blattfeder ausgebildeten Federmittel unter rauhen Umgebungsbedingungen brechen können.

Ein weiterer Nachteil besteht darin, daß die Kontaktwölbung lediglich tangential an dem beteiligten Anschlußbereich zur Anlage kommt. Dadurch ist es nicht möglich, eine hochbelastbare elektrische Verbindung, durch die hohe Ströme fließen können, herzustellen. Das heißt, daß die Kontaktfläche an sich zu klein ist.

Außerdem ist es von Nachteil, daß vor der Kontaktierung die Kontaktwölbungen mittels eines zusätzlichen Arbeitsschrittes in die Flachbandleitung eingebracht werden müssen. Damit verbunden ist eine hohe Präzision bei der Positionierung der Kontaktwölbungen, damit diese genau an der Stelle in der Flachbandleitung eingebracht werden, in der später die Federmittel eingreifen können. Befindet sich nämlich das Federmittel nicht genau in dem Bereich, in dem eine Kontaktwölbung in der Flachbandleitung vorhanden ist, werden nur unzureichend hohe Kräfte oder ausreichend hohe Kräfte außerhalb des Kontaktbereiches aufgebracht und eine sichere Kontaktierung ist nicht möglich.

Dokument US-A-4 184 729 offenbart eine Vorrichtung nach dem Oberbegriff des Anspruchs 1.

Der Erfindung liegt daher die Aufgabe zugrunde, die eingangs geschilderten Nachteile zu vermeiden und eine Vorrichtung zum Verbinden von elektrischen Leitern bereitzustellen, die bei zuverlässiger Kontaktierung einfach herstellbar ist.

Diese Aufgabe ist durch die Merkmale des Patentanspruches 1 gelöst.

Erfindungsgemäß ist vorgesehen, daß die Druckmittel ihre Kraft derart auf die Kontaktbereiche der elektrischen Leiter ausüben, daß nach der Verbindung die Kontaktbereiche der zumindest beiden elektrischen Leiter plastisch verformt sind.

Dadurch ist zum einen der Vorteil gegeben, daß ein zusätzlicher Schritt zur Herstellung von Kontaktwölbungen entfallen kann, da die Kontaktwölbung erst aufgrund der Druckausübung der Druckmittel der beteiligten Kontaktbereiche hergestellt wird. Es können somit beliebige elektrische Leiter wie Flachbandleitungen, Leiterplatten oder Flachbandfolien verwendet werden, die vorher außer der Abisolierung nicht bearbeitet werden müssen. Das heißt, daß die beteiligten Kontaktbereiche in dem Bereich plastisch verformt werden, in dem sich die Druckmittel befinden. Zusätzlich können Puffer vorhanden sein, die elastisch verformbar sind und nach der Verbindung eine zusätzliche Kontaktkraft aufbringen, insbesondere über die Lebensdauer der Verbindung.

Die plastische Verformung der beteiligten elektrischen Leiter im Kontaktbereich hat darüber hinaus den Vorteil, daß die größtmögliche Fläche der zu kontaktierenden Kontaktbereiche zur Anlage kommt, so daß eine hohe Kontaktsicherheit gegeben ist. Durch die großflächige Kontaktierung ist es gleichzeitig möglich, auch hohe Ströme bei verhältnismäßig dünnen bzw. flachen elektrischen Leitern zu übertragen. Da die Druckmittel nicht unbedingt federkraftbeaufschlagt sein müssen (aber können), entfällt auch das Risiko eines Federbruches, aus dem eine Kontaktunterbrechung resultieren würde. Ein weiterer Vorteil besteht darin, dass aufgrund der plastischen Verformung Oxidschichten aufbrechen und damit die Kontaktierung weiter verbessert wird.

In Weiterbildung der Erfindung sind die Druckmittel und die Kontaktbereiche in einem Gehäuse, insbesondere in einem mehrteiligen Gehäuse, angeordnet. Durch die Verwendung eines Gehäuses können die Druckmittel sowie die beteiligten elektrischen Leiter lagefixiert werden, wodurch gleichzeitig die Kontaktbereiche vor mechanischen Beschädigungen geschützt werden. Außerdem kann das Gehäuse dazu dienen, die gesamte Anordnung an einer gewünschten Stelle zu positionieren.

In Weiterbildung der Erfindung können die Kontaktbereiche zusätzlich von einer Dichtung dichtend abgeschlossen werden. Dadurch können Umgebungs- bzw. Umwelteinflüsse (wie beispielsweise Feuchtigkeit, Verschmutzungen durch elektrisch leitende Partikel und dergleichen) nicht auf die Kontaktbereiche einwirken, so daß Korrosionen, Kurzschlüsse und dergleichen wirksam vermieden werden. In besonders vorteilhafter Weise besteht das Gehäuse aus zwei Hälften, wobei das Innere des Gehäuses durch eine zwischen beide Gehäusehälften eingelegte Dichtung dichtend verschlossen ist. Diese Dichtung kann zwischen den Gehäusehälften eingelegt werden oder an den äußeren Konturen einer Gehäusehälfte vormontiert (zum Beispiel angespritzt) sein. Diese Dichtung hat vor allem die Aufgabe, zu verhindern, dass zwischen mehreren Kontaktbereichen ein Kurzschluß entsteht.

Durch die Dichtung wird sichergestellt, dass jeder Kontaktbereich, mehrere Kontaktbereiche oder alle Kontaktbereiche vor äußeren Einflüssen (wie Feuchtigkeit, elektrisch leitende Partikel oder dergleichen) geschützt sind, damit keine Kurzschlüsse entstehen.

Die Dichtung kann alle Kontaktbereiche umfassen oder aber auch nur zwischen zwei Leiterbahnen um einen Kontaktbereich herum angeordnet sein.

In Weiterbildung der Erfindung ist zumindest ein Teil der Druckmittel elektrisch leitend. Dies hat den Vorteil, daß die Druckmittel zweierlei Funktionen übernehmen können. Zum einen bewirken sie nach der Verbindung und Kontaktierung der elektrischen Leiter deren plastische Verformung. Zum anderen können sie zur weiteren Kontaktierung genutzt werden, da sie sich in einem Kontaktbereich eines elektrischen Leiters befinden. So können beispielsweise die Druckmittel als Kontaktbuchse oder als Kontaktstift ausgebildet sein. An dieser Buchse bzw. dem Stift können weitere elektrische Leiter, Stecker, elektrische Bauelemente (wie zum Beispiel Bücken) oder elektronische Bauelemente oder sogar elektronische Module angeschlossen werden. In einer besonders vorteilhaften Ausgestaltung der Erfindung sind mehrere nebeneinander angeordnete Druckmittel zum einen zur Kontaktierung und plastischen Verformung ausgebildet und zum anderen als mehrpoliger Stecker oder als mehrpolige Buchse ausgestaltet, über die eine Signal- oder Spannungsübertragung erfolgen kann.

In Weiterbildung der Erfindung sind die Druckmittel kraftbeaufschlagt. Dies hat den zusätzlichen Vorteil, daß die großflächig aufeinanderliegenden und plastisch verformten und somit angepaßten Kontaktbereiche nach der Kontaktierung zusätzlich von einer Kraft beaufschlagt werden, so daß die Kontaktierung noch zuverlässiger ist. Die Kraft kann mittels einer Feder oder aber auch durch eine elastisch verformbare Zwischenlage erzeugt werden.

In der Erfindung liegen die elektrischen Leiter zumindest im Kontaktbereich planparallel übereinander auf einer Unterlage auf, wobei die plastische Verformung im Kontaktbereich und Anlagebereich der Unterlage erfolgt. Dadurch können auf einfache Art und Weise die elektrischen Leiter planparallel übereinandergelegt werden und anschließend die Druckmittel montiert werden, so daß durch die Montage der Druckmittel die Kontaktbereiche der zumindest beiden elektrischen Leiter plastisch verformt werden. Diese plastische Verformung kann derart erfolgen, daß die Unterlage ebenfalls oder nicht plastisch verformt wird. Soll die Unterlage nicht verformt werden, muß sie eine Materialeigenschaft aufweisen, die der Kraftausübung der Druckmittel standhält. In einem solchen Fall kann daran gedacht werden, daß sich die Druckmittel bei Kraftausübung ebenfalls zumindest teilweise plastisch verformen. Andererseits kann die Unterlage aus einem Material bestehen, welches sich unter Kraftausübung und plastischer Verformung der Kontaktbereiche ebenfalls mit verformt. Besteht das Material der Unterlage nicht aus einem plastisch verformbaren Material, kann auch daran gedacht werden, zwischen der Unterlage und dem zumindest einen elektrischen Leiter eine plastisch verformbare Auflage einzubringen, die sich nach Kraftausübung durch die Druckmittel plastisch verformt. Diese Auflage oder andere geeignete Mittel halten dann aufgrund ihrer Elastizität die Verbindung über die Lebensdauer der Vorrichtung aufrecht.

In Weiterbildung der Erfindung liegen die elektrischen Leiter zumindest im Kontaktbereich planparallel übereinander zwischen zumindest zwei Druckmitteln, wobei die plastische Verformung in den Kontaktbereichen erfolgt. In vorteilhafter Weise liegen sich jeweils zwei Druckmittel im Kontaktbereich gegenüber, so daß die dazwischen liegenden elektrischen Leiter plastisch verformt werden können. Dabei ist selbstverständlich darauf zu achten, daß die Kraftausübung der gegenüberliegenden Druckmittel nicht so hoch ist, daß diese die Kontaktbereiche der beteiligten elektrischen Leiter durchstoßen würden, so daß eine Kontaktierung verhindert würde.

Verschiedene Ausführungsbeispiele der Erfindung, auf die die Erfindung jedoch nicht beschränkt ist, sind im folgenden beschreiben und anhand der Figuren erläutert.

Es zeigen:
- Figuren 1 und 2:: Vorrichtungen zum Verbinden von elektrischen Leitern vor der Montage,
- Figuren 3 und 4:: Vorrichtungen zum Verbinden von elektrischen Leitern nach ihrer Montage,
- Figuren 5 und 7:: ein weiteres Ausführungsbeispiel einer Vorrichtung zum Verbinden von elektrischen Leitern,
- Figuren 8 und 10:: eine Vorrichtung zum Verbinden von elektrischen Leitern mit einem Stecker,
- Figuren 11:: eine Mikroskopaufnahme im Schnitt.

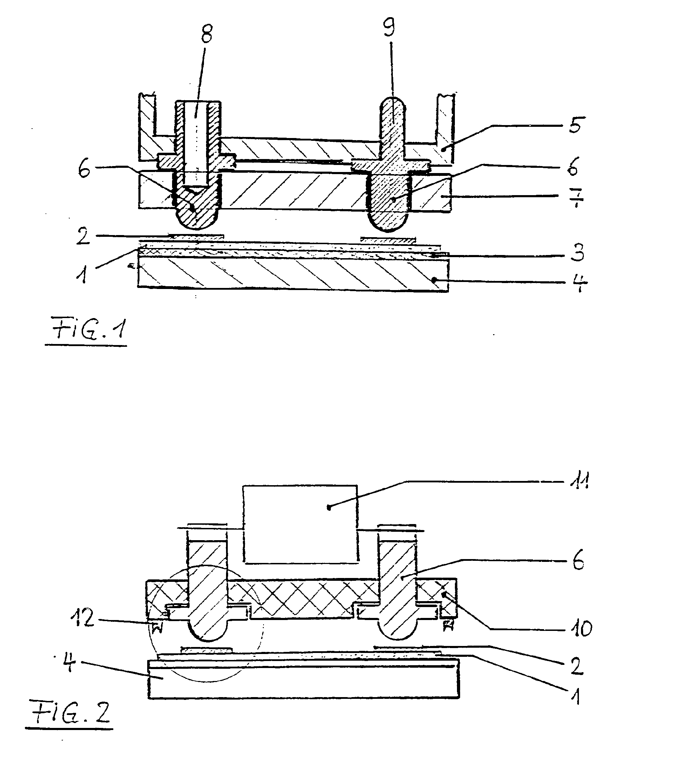

In Figur 1 ist eine Schnittzeichnung durch eine beispielhafte Vorrichtung zum Verbinden von elektrischen Leitern dargestellt. Mit den Bezugsziffern 1 und 2 sind eine erste und eine weitere Flachbandleitung bezeichnet, die im dargestelltem Kontaktbereich abisoliert sind und planparallel übereinander liegen. Bei Betrachtung der Figur 1 befindet sich unter der ersten Flachbandleitung 1 eine plastisch verformbare Auflage 3, welche wiederum auf einer nicht plastisch verformbaren Unterlage 4 aufliegt. Mit der Bezugsziffer 5 ist ein Gehäuse bezeichnet, welches sich oberhalb der Unterlage 4 befindet, wobei die Unterlage 4 Bestandteil des Gehäuses 5 sein kann. In dem Gehäuse 5 sind zwei Druckmittel 6 angeordnet, die, wenn das Gehäuse 5 zwecks Montage in Richtung der Unterlage 4 bewegt und anschließend festgesetzt wird, die beiden Druckmittel 6 aufnimmt. Die beiden Druckmittel 6 durchstoßen noch eine Zwischenlage 7, welche in etwa planparallel zu der Unterlage 4 angeordnet ist.

In Figur 1 ist noch gezeigt, daß die Druckmittel 6 einmal als Kontaktbuchse 8 und einmal als Kontaktstift 9 ausgebildet sind. Sind die Druckmittel 6 als Kontaktbuchse 8 bzw. Kontaktstift 9 ausgebildet, ist in ergänzender Weise auch das Gehäuse 5 bzw. ein Teil davon als Stecker oder Buchse ausgebildet.

Entgegen der in Figur 1 gezeigten Ausführung können die Druckmittel auch aus einer planparallelen Platte bestehen, die Auswölbungen im Bereich der Kontaktbereich der beiden Flachbandleitungen 1 und 2 aufweisen. Diese Platte (bzw. das Gehäuse 5 und die Zwischenlage 7) wird zwecks Verbindung und Kontaktierung in Richtung der Unterlage 4 bewegt und nach erfolgter Kontaktierung festgesetzt.

Figur 2 zeigt eine ähnliche Ausgestaltung wie in Figur 1 vor ihrer Montage, wobei hier dargestellt ist, daß es sich bei der Bezugsziffer 10 um ein Gehäuseoberteil handelt, welches die Druckmittel 6, die als Kontakte ausgebildet sind, aufnimmt. Zwischen diesen beiden Kontakten (Druckmittel 6) ist ein elektronisches Bauelement 11 geschaltet. Anstelle eines elektronischen Bauelementes könnte hier auch eine Brücke oder ein elektronisches Modul (also mit mehreren elektronischen Bauelementen) angeordnet sein.

Weiterhin ist in Figur 2 noch gezeigt, daß das Gehäuseoberteil 10 eine umlaufende Dichtung 12 aufweist, wobei die Dichtung 12 auch an der Unterlage 4, die Bestandteil des Gehäuses ist, angebracht sein kann. Alternativ dazu ist es auch denkbar, daß die Dichtung 12 zwischen der Unterlage 4 und dem Gehäuseoberteil 10 eingesetzt wird. Mit der Dichtung 12 wird erreicht, daß mehrere Kontaktbereiche der beiden Flachbandleitungen 1 und 2 vor äußeren Einflüssen geschützt sind.

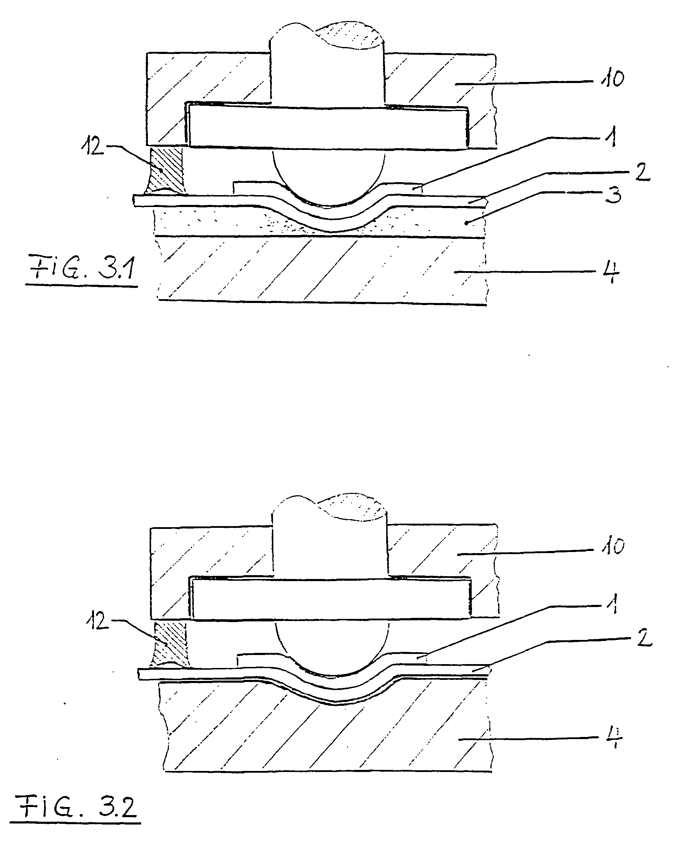

Figur 3 (Figuren 3.1 und 3.2) zeigt die erfindungsgemäße Vorrichtung zum Verbinden von elektrischen Leitern nach ihrer Montage, wobei ausschnittsweise die in Figur 2 dargestellte Vorrichtung wiedergegeben ist, allerdings nach ihrer Montage. Es ist in Figur 3.1 zu erkennen, daß das Gehäuseoberteil 10 mit seinem Druckmittel 6 in Richtung der Unterlage 4 bewegt wurde, so daß das pilzförmige Ende der Druckmittel 6 seine Kraft auf die Kontaktbereiche der ersten und der weiteren Flachbandleitungen 1 und 2 ausüben konnte und diese entsprechend plastisch verformt hat. Gleichzeitig wurde auch die Auflage 3 plastisch mit verformt, wobei die Unterlage 4 aus einem Material besteht, die dem ausgeübten Druck standhält. Wie in Figur 3 deutlich zu erkennen ist, liegen die beiden Flachbandleitungen 1 und 2 in ihrem Kontaktbereich auf einer größtmöglichen Fläche aufeinander, so daß die höchstmöglich Kontaktierung gegeben ist. Da nach dieser Montage das Gehäuseoberteil 10 unbeweglich in bezug auf die Unterlage 4 montiert ist, wird nach wie vor eine Kraft auf die Kontaktbereiche ausgeübt, was entweder dadurch erfolgen kann, daß die plastisch verformte Auflage 3 die Kraft ausübt oder die Druckmittel 6 federkraftbeaufschlagt sind.

Weiterhin ist in Figur 3.1 noch zu erkennen, wie die Dichtung 12 diesmal nicht auf der Unterlage 4, sondern auf der einen Flachbandleitung 2 zur Auflage kommt. Damit ist es möglich, die Dichtwirkung beizubehalten bei gleichzeitiger Herausführung der einen Flachbandleitung 2. Diese Dichtung 12 kann um die gesamte Vorrichtung herum, um Kontaktbereichsgruppen oder um einzelne Kontaktbereiche herum angeordnet sein. Figur 3.2 zeigt eine ähnliche Ausgestaltung wie Figur 3.1, wobei jedoch die plastisch verformbare Auflage 3, die elastische Eigenschaften hat (wie bei Figur 3.1), fehlt. Dafür ist die Unterlage 4 plastisch verformbar und hat vorzugsweise elastische Eigenschaften. Außerdem kann die Unterlage 4 Ausnehmungen aufweisen, die geringfügig kleiner sind als die Form der korrespondierenden Druckmittel, wobei sich die Kontaktbereiche in den Ausnehmungen anschmiegen.

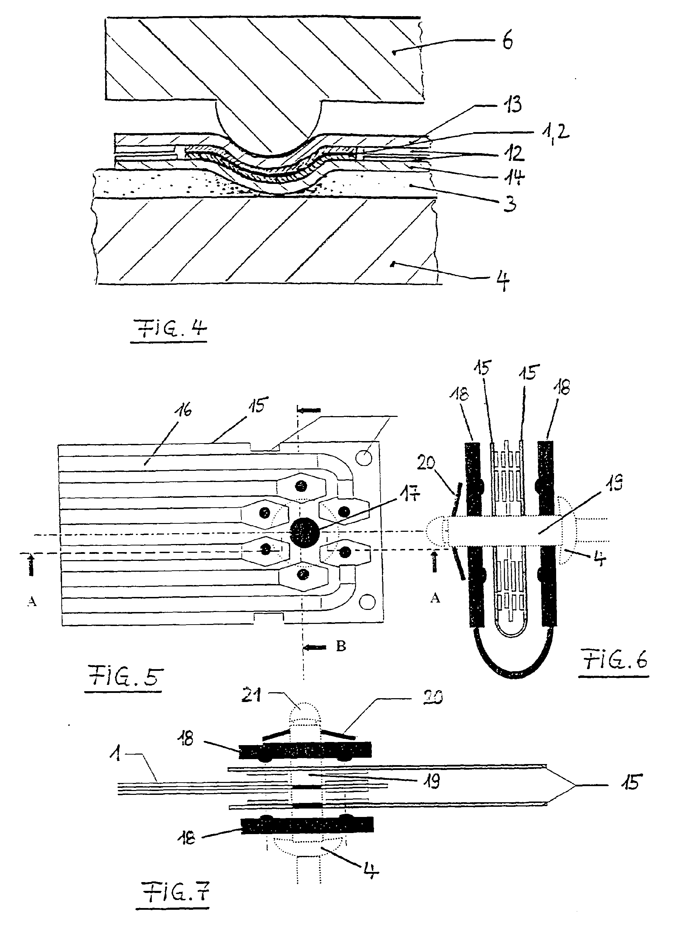

Figur 4 zeigt eine weitere Vorrichtung zum Verbinden von elektrischen Leitern nach ihrer Montage, wobei dargestellt ist, daß die Druckmittel 6 keinerlei elektrische Funktion übernehmen, sondern als planparallele Platte mit pilzförmigen Auswölbungen ausgebildet sind. Bei den in Figur 4 dargestellten zu verbindenden elektrischen Leitern handelt es sich um Leiterplatten 13 und 14, zwischen denen sich die Kontaktbereiche der ersten und der weiteren Flachbandleitungen 1 und 2 befinden, so daß diese mit den Kontaktbereichen der Leiterplatten verbunden werden können. Auch hier befindet sich zwischen den Leiterplatten 13 und 14 eine zwischengelegte Dichtung 12, die die Kontaktbereiche vor Umwelteinflüssen schützt.

In den Figuren 5 bis 7 sind weitere verschieden Möglichkeiten der Ausgestaltung und der Vorrichtung zum Verbinden von elektrischen Leitern dargestellt.

Figur 5 zeigt eine Leiterplatte 15 mit mehreren darauf angeordneten Leiterbahnen 16, wobei hervorzuheben ist, daß die Endbereiche der Leiterbahnen 16 konzentrisch um eine Bohrung 17 in der Leiterplatte 15 herum angeordnet sind. Eine ovale, parallele oder lineare Anordnung der Endbereiche ist zudem auch denkbar.

In Figur 6 ist gezeigt, daß zumindest zwei solcher Leiterplatten 15, wie sie in Figur 5 dargestellt sind, planparallel übereinander liegen. Zu diesem Zweck sind die einzelnen Leiterbahnen 16 der beteiligten Leiterplatten 15 aneinander zugewandt. Ebenso planparallel sind zwei Druckplatten 18 angeordnet, wobei die Druckplatten 18 konzentrisch um die Bohrung 17 herum genau an den Stellen, an denen die Leiterbahnen 16 enden, Druckmittel (hier pilzförmige Erhebungen) aufweisen. Auch die Druckplatten 18 weisen eine nicht bezeichnete Bohrung auf, wobei in die beiden Bohrungen ein Verbindungsmittel 19 eingeführt werden kann, welches einerseits die Unterlage 4, die zur Anlage an der einen Druckplatte 18 kommt, aufweist. Bei der Betrachtung der linken Seite der Figur 6 wird eine Feder 20 (Tellerfeder) aufgesetzt und durch das Verbindungsmittel 19 gespannt, welches beispielsweise in seinem Inneren ein Gewinde aufweisen kann, in dem vom links eine Schraube eingedreht wird, welche bewirkt, daß die beiden Leiterplatten 15 und die Druckplatten 16 planparallel in Richtung der Unterlage 4 aneinander gedrückt werden. Durch diese Bewegung erfolgt aufgrund der Erhebungen in den Druckplatte 18 eine geringfügige plastische Verformung der Leiterplatte 15 bzw. der Endbereiche der Leiterbahnen 16, so daß diese sich aneinander anschmiegen und die höchstmögliche Kontaktierung gegeben ist. Wie in Figur 6 dargestellt ist, kann sich zwischen den beiden Leiterplatten 15 noch eine weitere Flachbandleitung, eine zweiseitig beschichtete Leiterplatte oder eine elektrische Leiterfolie befinden, muß aber nicht vorhanden sein. Figur 6 zeigt, daß die beiden Druckplatten 18 über eine biegsame Lasche miteinander verbunden sind, über welche gewährleistet ist, daß die pilzförmigen Erhebungen der Druckplatten 18 sich auch während bzw. nach der Montage immer im Bereich der konzentrisch angeordneten Enden der Leiterbahnen 16 um die Bohrung 17 herum befinden. Ein solches Gebilde kann beispielsweise aus Kunststoff als Spritzgußteil hergestellt sein. Die biegsame Lasche kann vor oder nach der Montage entfernt werden.

Figur 7 zeigt eine ähnliche Anordnung, bei der die Flachbandleitungen 1 mit zwei Leiterplatten 15 verbunden wird. Auch hier weist wieder zumindest die eine Leiterplatte 15 Leiterbahnen 16 auf, die entsprechend der Ausführung gemäß Figur 5 angeordnet sind. Entgegen dem in Figur 6 dargestellten Ausführungsbeispiel sind die beiden Druckplatten 18 nicht über eine Lasche miteinander verbunden. Die Montage der in Figur 7 gezeigten Vorrichtung zum Verbinden von elektrischen Leitern erfolgt beispielsweise in der folgenden beschriebenen Art und Weise: das mechanische Verbindungsmittel 19 weist schon die Unterlage 4 auf, auf welche die untere Druckplatte 18, die ebenfalls eine Bohrung aufweist, aufgeschoben wird. Anschließend wird die Leiterplatte 15. Die Flachbandleitung 1 und die weitere Leiterplatte 15 aufgeschoben und die obere Druckplatte 18 aufgesetzt. Danach wird noch die Feder 20 montiert und die beteiligten Elemente durch ein Blindniet 21 in Richtung der Unterlage 4 zusammengedrückt. Anschließend kann in nicht dargestellter Weise die in Figur 7 gezeigte Anordnung von einem Gehäuse verschlossen werden. Das mechanische Verbindungsmittel 19 kann aus elektrisch leitendem oder isolierendem Material bestehen und ggf. zur Kontaktierung oder Durchleitung von Spannungen oder Signalen oder zur Realisierung eines Massepunktes ausgestaltet sein.

Die Feder 20 kann auch durch eine elastisch verformbare Zwischenlage zwischen den Leiterplatten 15 ersetzt oder ergänzt werden.

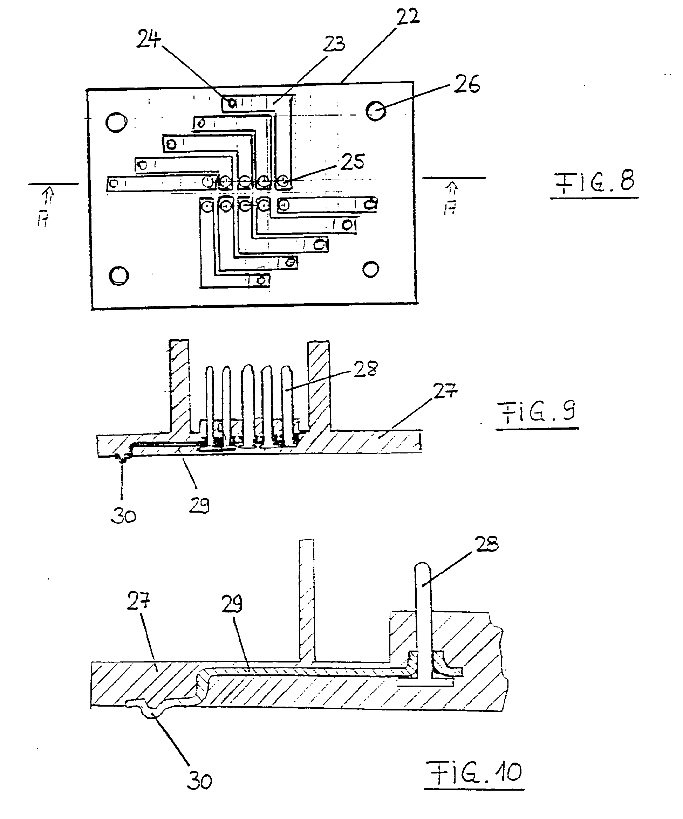

In den Figuren 8 bis 10 ist eine Vorrichtung zum Verbinden von elektrischen Leitern mit einem Stecker gezeigt. Während es bei den vorangegangenen Ausführungsbeispielen im wesentlichem darauf ankam, zumindest zwei elektrische Leiter wie Flachbandleitungen oder dergleichen miteinander zu verbunden, geht es bei dem Ausführungsbeispiel, welches in den Figuren 8 bis 10 gezeigt ist, entweder darum, zumindest zwei Flachbandleitungen miteinander zu kontaktieren und über einen Stecker oder dergleichen die zumindest eine Flachbandleitung abzugreifen oder schon kontaktierte Flachbandleitungen über den Stecker abzugreifen. Es muss nicht unbedingt ein Stecker zum Einsatz kommen. Es kann auch eine Buchse, ein elektrisches (Brücke) oder elektronisches Bauteil (z.B. Widerstand, Spule, Kondensator) oder ein elektronisches System (z.B. Mikroprozessor, Modul) verwendet werden.

Dazu ist in Figur 8 eine Leiterplatte 22 gezeigt, auf der mehrere Leiterbahnen 23 (hier rechtwinklig angeordnet, im allgemeinen ist die Anordnung jedoch beliebig) angeordnet sind. An den Enden einer jeden Leiterbahn 23 ist jeweils ein Kontaktpunkt 24 und 25 vorhanden. In den äußeren Bereiche3n der Leiterplatte 22 sind Bohrungen 26 vorhanden, durch welche die Verbindungsmittel durchgeführt werden können.

In Figur 9 ist ein Stecker 27 gezeigt, der von seinen Grundabmessungen in etwa die gleichen Grundabmessungen aufweist wie die Leiterplatte 22. Der Stecker 27 weist mehrere Kontaktstifte 28 auf, wobei ein jeder Kontaktstift 28 über einen Leiterstreifen 29 innerhalb des Steckers 27 nach außen geführt ist und mit einer Kontaktfahne 30 endet. Jede der nach außen geführten Kontaktfahnen 30 korrespondiert mit der Lage des betreffenden Kontaktpunktes 24 der Leiterplatte 22. Auch der Stecker 27 weist, korrespondierend zu der Lage der Bohrungen 26, ebenfalls Bohrungen, die nicht bezeichnet sind, auf.

Die Leiterplatte 22 und der Stecker 27, wie sie in den Figuren 8 und 9 gezeigt sind, können in der folgenden Weise miteinander kombiniert werden:

Entweder wird der Stecker 27 planparallel auf die Leiterplatte 22 aufgesetzt und mit Verbindungsmitteln (wie Niete oder dergleichen, die durch die Bohrungen 26 geführt werden) derart miteinander Verbunden, daß die Kontaktfahnen 30, unter denen sich eine leichte Erhebung des Steckers 27 befindet, unter Druck zur Anlage auf den Kontaktpunkten 24 kommen, so daß wenigstens die Leiterbahn 23 im Bereich des Kontaktpunktes 24 nach Anlage der Kontaktfahne 30 plastisch verformt wird.

Es ist aber auch möglich, daß zwischen die Leiterplatte 22 und dem Stecker 27 eine weitere Flachbandleitung gelegt wird, die mit wenigstens einem Kontaktpunkt 25 verbunden werden soll. Zu diesem Zweck ist die dazwischen gelegte Flachbandleitung (oder auch mehrere Flachbandleitungen) an den Stellen, an denen die betreffende Leiterbahn mit dem Kontaktpunkt 25 kontaktiert werden soll, abisoliert, wobei gleichzeitig der Stecker 27 an seiner Unterseite Erhebungen in Form des Druckmittels 6 aufweist, so daß nach dem Zusammenfügen der Leiterplatte 22 und dem Stecker 27 einschließlich der dazwischen gelegte durch plastische Verformung kontaktiert werden.

In Figur 10 ist eine Herstellungsart eines Steckers 27 gezeigt, bei dem der Stecker 27 aus Kunststoff besteht und die Leiterstreifen 29 als vom Kunststoff umgebenes Stanzgitter ausgebildet sind. Weiterhin ist in Figur 10 deutlich erkennbar, daß hier die Kontaktfahnen 30 als Wölbung ausgebildet ist, wodurch das Druckmittel zur plastischen Verformung gebildet wird. Im der Kontaktfahne 30 abgewandten Bereich weist der Leiterstreifen 29 den Kontaktstift auf, der in eine Bohrung des Leiterstreifens 29 eingedrückt wird, wobei der Leiterstreifen 29 in seinem Endbereich in die in Figur 10 gezeigt Form um den Kontaktstift 28 herum gebracht wird, wodurch der Kontaktstift 28 zuverlässig in seiner Lage gehalten wird.

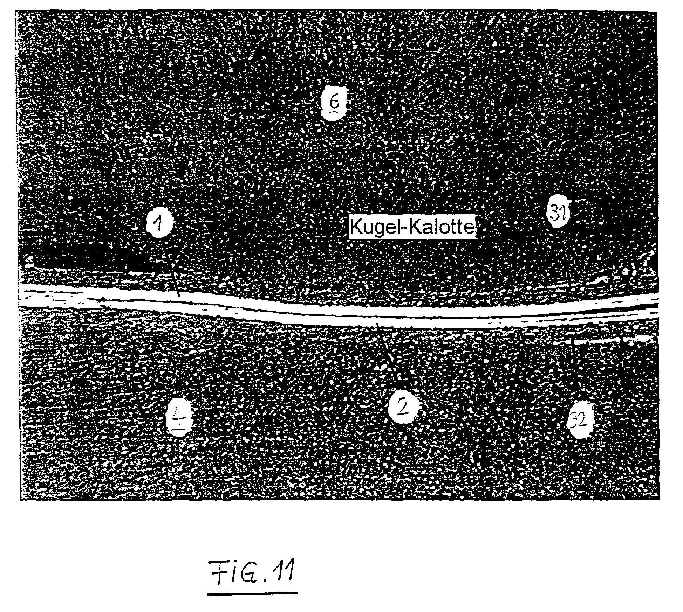

Figur 11 zeigt eine Mikroskopaufnahme einer Vorrichtung zum Verbinden von elektrischen Leitern im Schnitt. Mit den Bezugsziffern 1 und 2 sind die Flachbandleitungen, d. h., der elektrisch leitende Teil der Flachbandleitung, bezeichnet. Diese sind auf einem jeweiligen Träger 31 und 32 angeordnet, wobei der Träger 31 bzw. 32 ein dünner, flexibler Kunststoffträger sein kann. Denkbar ist aber auch, daß der Träger 31 und 32 starr und somit wenig plastisch verformbar ist oder der eine Träger flexibel und der andere Träger starr. Nach dem Übereinanderlegen der beiden Flachbandleitungen auf der Unterlage 4 wird durch Anlegen des Druckmittels 6 und Herstellen der Preßverbindung (wie beispielsweise durch den Blindniet) im Bereich des Druckmittels 6 ein so hoher, partiell wirkender Druck erzeugt, daß sich sowohl die Flachbandleitung als auch der Träger (und ggfs. die Unterlage 4) plastisch verformen. Dabei ist der Druck im Bereich des Druckmittels 6 so hoch, daß die elektrisch leitenden Bereiche der Flachbandleitungen 1 und 2 derart zusammengepreßt werden, daß im Kontaktbereich dieser luft- und gasdicht und dicht gegenüber anderen Einflüssen abgeschlossen ist. Bei entsprechend hoher Druckausübung kommt es sogar zu einer Kaltverschweißung der elektrisch zu kontaktierenden Bereiche, wodurch die sichere Verbindung auf jeden Fall hergestellt ist.

Daher erübrigen sich weitere Verbindungsmaßnahmen wie Löten oder dergleichen, so daß nur aufgrund des aufgebrachten Druckes die elektrische Kontaktierung hergestellt und auf Dauer gewährleistet ist, wobei auf zusätzliche Abdichtungsmaßnahmen bezüglich der Kontaktierung verzichtet werden kann. Es können aber Abdichtungsmaßnahmen hinsichtlich einzelner, mehrerer oder aller Kontaktbereiche bezüglich der Kurzschlußsicherheit vorgenommen werden.

## Patentansprüche

1. Vorrichtung zum Verbinden von elektrischen Leitern, wie Flachbandleitungen, Leiterplatten oder dergleichen, wobei in einem abisolierten Kontaktbereich der zu verbindenden elektrischen Leiter Druckmittel vorhanden sind, die eine Kraft auf zumindest einen der zu verbindenden elektrischen Leiter ausüben, **dadurch gekennzeichnet, dass** die Druckmittel (6) ihre Kraft derart auf die Kontaktbereiche ausüben, dass nach der Verbindung zumindest einer der elektrischen Leiter im Kontaktbereich plastisch verformt ist und die elektrischen Leiter zumindest in dem Kontaktbereich planparallel übereinander auf einer Unterlage (4) aufliegen und die plastische Verformung im Kontaktbereich und im Anlagebereich der Unterlage (4) erfolgt.

2. Vorrichtung nach Anspruch 1, **dadurch gekennzeichnet, daß** die Druckmittel (6) und die Kontaktbereiche in einem Gehäuse (4, 5), insbesondere in einem mehrteiligen Gehäuse, angeordnet sind.

3. Vorrichtung nach Anspruch 1 oder 2, **dadurch gekennzeichnet, daß** zumindest ein Kontaktbereich von einer Dichtung (12) dichtend angeschlossen sind.

4. Vorrichtung nach Anspruch 3, **dadurch gekennzeichnet, dass** die Dichtung (12) um zumindest den einen Kontaktbereich zwischen den Leitern angeordnet ist.

5. Vorrichtung nach einem der vorhergehenden Ansprüche, **dadurch gekennzeichnet, daß** zumindest ein Teil der Druckmittel (6) elektrisch leitend ausgebildet sind.

6. Vorrichtung nach einem der vorhergehenden Ansprüche, **dadurch gekennzeichnet, daß** die Druckmittel (6) nach der Verbindung zusätzlich kraftbeaufschlagt sind.

7. Vorrichtung nach einem der vorhergehenden Ansprüche, **dadurch gekennzeichnet, daß** die elektrischen Leiter planparallel übereinander zwischen zumindest zwei Druckmitteln (6) liegen und die plastische Verformung in den Kontaktbereichen erfolgt.

8. Vorrichtung nach einem der vorhergehenden Ansprüche, **dadurch gekennzeichnet, dass** die Endbereiche der elektrischen Leiter konzentrisch um die Verbindungsmittel herum angeordnet sind.

## Claims

1. Apparatus for connection of electrical conductors, such as flat ribbon lines, printed circuit boards or the like, with pressure means being provided in a stripped contact area of the electrical conductor to be connected and exerting a force on at least one of the electrical conductors to be connected, **characterized in that** the pressure means (6) exert their force on the contact areas such that, after the connection of at least one of the electrical conductors, plastic deformation occurs in the contact area and the electrical conductors rest plane-parallel one above the other on a base (4) at least in the contact area, and the plastic deformation takes place in the contact area and in the resting area of the base (4).

2. Apparatus according to Claim 1, **characterized in that** the pressure means (6) and the contact areas are arranged in a housing (4, 5), in particular in a multipiece housing.

3. Apparatus according to Claim 1 or 2, **characterized in that** at least one contact area is connected by a seal (12), forming a seal.

4. Apparatus according to Claim 3, **characterized in that** the seal (12) is arranged around at least one of the contact areas between the conductors.

5. Apparatus according to one of the preceding claims, **characterized in that** at least a portion of the pressure means (6) is designed to be electrically conductive.

6. Apparatus according to one of the preceding claims, **characterized in that** the pressure means (6) additionally has force applied to it after connection.

7. Apparatus according to one of the preceding claims, **characterized in that** the electrical conductors lie plane-parallel one above the other between at least two pressure means (6), and the plastic deformation takes place in the contact areas.

8. Apparatus according to one of the preceding claims, **characterized in that** the end areas of the electrical conductors are arranged concentrically around the connecting means.

## Revendications

1. Dispositif pour connecter des conducteurs électriques, comme des câbles plats, des plaquettes de circuits imprimés ou similaires, dans lequel, dans une région de contact isolée des conducteurs électriques à connecter, sont prévus des moyens de pression qui exercent une force sur au moins l'un des conducteurs électriques à connecter, **caractérisé en ce que** les moyens de pression (6) exercent leur force sur les régions de contact de telle sorte qu'après la connexion, au moins l'un des conducteurs électriques dans la région de contact soit déformé plastiquement et que les conducteurs électriques s'appliquent au moins dans la région de contact de manière plan-parallèle les uns sur les autres sur un subjectile (4), et que la déformation plastique ait lieu dans la région de contact et dans la région d'appui du subjectile (4).

2. Dispositif selon la revendication 1, **caractérisé en ce que** les moyens de pression (6) et les régions de contact sont disposés dans un boîtier (4, 5), notamment un boîtier en plusieurs parties.

3. Dispositif selon la revendication 1 ou 2, **caractérisé en ce qu'**au moins une région de contact est fermée hermétiquement par un joint d'étanchéité (12).

4. Dispositif selon la revendication 3, **caractérisé en ce que** le joint d'étanchéité (12) est disposé autour d'au moins l'une des régions de contact entre les conducteurs.

5. Dispositif selon l'une quelconque des revendications précédentes, **caractérisé en ce qu'**au moins une partie des moyens de pression (6) est réalisée de manière électriquement conductrice.

6. Dispositif selon l'une quelconque des revendications précédentes, **caractérisé en ce que** les moyens de pression (6) sont sollicités par une force supplémentaire après la connexion.

7. Dispositif selon l'une quelconque des revendications précédentes, **caractérisé en ce que** les conducteurs électriques sont posés de manière plan-parallèle les uns sur les autres entre au moins deux moyens de pression (6) et la déformation plastique a lieu dans les régions de contact.

8. Dispositif selon l'une quelconque des revendications précédentes, **caractérisé en ce que** les régions d'extrémité des conducteurs électriques sont disposées concentriquement autour des moyens de connexion.
